# EUROPÄISCHE PATENTANMELDUNG

(11) **EP 1 136 831 A1**
(43) Veröffentlichungstag der Anmeldung: **26.09.2001**
(21) Anmeldenummer: 00106304.9
(22) Anmeldetag: 23.03.2000
(51) Int. Cl.: G01R 29/08, G01R 31/00

(54) **Prüflingsmanipulator für TEM-Zellen**

(71) Anmelder: Siemens Building Technologies AG, 8034 Zürich (CH)
(72) Erfinder: Pfenninger, Christoph, 8640 Rapperswil SG (CH); Gujer, Peter, 8708 Männedorf (CH)
(74) Vertreter: Dittrich, Horst, Dr.

(57) **Zusammenfassung**

Der Prüflingsmanipulator (M) für die Platzierung eines Prüflings in drei verschiedenen Raumpositionen weist eine rotierbare Prüflingshalterung sowie Mittel für deren Antrieb auf. Die Prüflingshalterung ist so ausgebildet, dass der Prüfling in einer Raumdiagonale eines Würfels in Schritten von 120° verdrehbar ist; sie ist auf einer Bodenplatte (7) angeordnet und weist eine parallel zur Bodenplatte (7) orientierte Prüflingsplatte (9) und eine diese tragende Antriebswelle (10) auf. Die Mittel für den Antrieb der Prüflingshalterung sind in einem auf der Bodenplatte (7) montierten Gehäuse (8) angeordnet. Die Antriebswelle (10) ist im Gehäuse (8) oder in einer auf der Bodenplatte (7) angeordneten Abstützung (11) so gelagert, dass ihre Längsachse in Richtung einer Raumdiagonalen eines Würfels orientiert ist.

## Beschreibung

Die vorliegende Erfindung betrifft einen Prüflingsmanipulator für TEM-Zellen für die Platzierung eines Prüflings in drei verschiedenen Raumpositionen innerhalb der Zellen.

TEM (Transversal ElectctroMagnetic)-Zellen werden für die Überprüfung der elektromagnetischen Verträglichkeit (EMV) das ist der elektromagnetischen Störfestigkeit und der elektromagnetischen Störaussendung, eingesetzt. Sie sind von der Konstruktion her geschlossene Streifenleitungen. Eine verbreitete Art von TEM-Zellen sind solche mit einem Anschlusspunkt und asymmetrischem Innenleiter, beispielsweise die sogenannten GTEM-Zellen. Bezüglich dieser auch als konische TEM-Zellen bezeichneten Zellen wird auf die Publikation "A new family of TEM-cells with enlarged bandwith and optimized working volume" von D. Koenigstein und D. Hansen in Proc. 7^{th} Int. Zurich Symp. and Technical Exhibition on electromagnetic Compat., March 1987, Seiten 127-132, verwiesen. Diese konischen TEM-Zellen weisen die Form eines Keiles oder einer Pyramide auf, an deren Spitze ein elektrischer Anschlusspunkt vorgesehen und auf deren der Spitze gegenüberliegende Grundfläche ein HF-Absorber aufgebracht ist. Damit der Prüfling immer im mittleren Drittel des elektromagnetischen Feldes liegt, ist ein Schaumstoffkeil mit einem entsprechenden Winkel vorgesehen.

Zur normenkonformen Überprüfung der EMV muss der Prüfling gemäss der Europäischen Norm EN 50130-4 (Europäischer Produktefamilienstandard: Elektromagnetische Verträglichkeit, Anforderungen an die Störfestigkeit von Anlageteilen für Brand- und Einbruchmeldeanlagen sowie Personen-Hilferufanlagen) der Beanspruchung eines elektromagnetischen Feldes in drei Ausrichtungen relativ zum Feld in der Weise unterzogen werden, dass die elektrischen (E-) und die magnetischen (H-) Anteile des Feldes an jeder der drei rechtwinkeligen Achsen des Prüflings angelegt werden.

Bisher wird der Prüfling auf einem speziellen Holzwinkel mit drei festen Seitenflächen befestigt, und der Winkel wird von Hand in die jeweilige Prüfposition gekippt. Das bedeutet, dass pro Prüfung die Position des Prüflings zweimal von Hand geändert muss, wobei zwischen den Positionswechseln etwa 10 bis 120 Minuten Messzeit liegen. Wegen der von Hand vorzunehmenden Positionswechsel ist es nicht möglich, eine Messung über Nacht laufen zu lassen, und damit die etwa CHF 150'000 teure Apparatur besser auszulasten.

Durch die Erfindung soll nun ein Prüflingsmanipulator für TEM-Zellen angegeben werden, welcher eine Automatisierung der Positionsänderungen des Prüflings ermöglicht. Dadurch soll es möglich werden, die Prüfung mit Ausnahme des Einsetzens des Prüflings in die Zelle und des Herausnehmens aus dieser automatisch ablaufen zu lassen.

Die gestellte Aufgabe wird erfindungsgemäss dadurch gelöst, dass der Prüflingsmanipulator eine rotierbaren Prüflingshalterung sowie Mittel für deren Antrieb aufweist, und dass die Prüflingshalterung so ausgebildet ist, dass der Prüfling in einer Raumdiagonalen eines Würfels in Schritten von 120° verdrehbar ist.

Wenn der Prüfling auf seiner Halterung befestigt und schrittweise in der Raumdiagonale eines Würfels zwischen 0°, 120° und 240° verdreht wird, wird die von der genannten Norm verlangte Ausrichtung des Prüflings relativ zum Feld auf einfache Weise erreicht.

Eine erste bevorzugte Ausführungsform des erfindungsgemässen Prüflingsmanipulators ist dadurch gekennzeichnet, dass die Prüflingshalterung auf einer Bodenplatte angeordnet ist und eine parallel zur Bodenplatte orientierte Prüflingsplatte und eine diese tragende Antriebswelle aufweist, und dass die Mittel für den Antrieb der Prüflingshalterung in einem auf der Bodenplatte montierten Gehäuse angeordnet sind.

Eine zweite bevorzugte Ausführungsform des erfindungsgemässen Prüflingsmanipulators ist dadurch gekennzeichnet, dass die Antriebswelle im Gehäuse oder in einer auf der Bodenplatte angeordneten Abstützung so gelagert ist, dass ihre Längsachse in Richtung einer Raumdiagonalen eines Würfels orientiert ist.

Eine dritte bevorzugte Ausführungsform ist dadurch gekennzeichnet, dass die Antriebswelle durch eine Hohlwelle gebildet und in der Abstützung in Längsrichtung verschieb- und justierbar gelagert ist.

Eine vierte bevorzugte Ausführungsform des erfindungsgemässen Prüflingsmanipulators ist dadurch gekennzeichnet, dass die Mittel für den Antrieb der Prüflingshalterung durch einen auf die Hohlwelle wirkenden pneumatischen Antrieb gebildet sind.

Eine fünfte bevorzugte Ausführungsform ist dadurch gekennzeichnet, dass der pneumatische Antrieb eine Flügelzelle mit einem auf einer ersten Welle befestigten Schwenkflügel, ein auf der genannten Welle befestigtes erstes Zahnrad und ein mit diesem in Eingriff stehendes und auf der Hohlwelle befestigtes zweites Zahnrad umfasst.

Eine weitere bevorzugte Ausführungsform des erfindungsgemässen Prüflingsmanipulators ist dadurch gekennzeichnet, dass die Kabel zu den elektrischen Anschlüssen des Prüflings durch die Hohlwelle zur Bodenplatte geführt sind.

Als Material wird vorzugsweise für die Bodenplatte und die Prüflingsplatte eine mitteldichte Faserplatte und für die anderen Teile des Prüfmanipulators Polyacetal (POM) verwendet. Diese Materialien beeinflussen das elektromagnetische Feld in der TEM-Zelle praktisch nicht. POM weist ausserdem solche mechanische Eigenschaften auf, dass es zur Verwendung für mechanisch beanspruchte Teile, wie beispielsweise Zahnräder oder auf Biegung beanspruchte Wellen, gut geeignet ist.

Im folgenden wird die Erfindung anhand eines Ausführungsbeispiels und der Zeichnungen näher erläutert; es zeigt:
- Fig. 1: einen Längsschnitt durch eine konische TEM-Zelle mit einem herkömmlichen Trägerwinkel für den Prüfling;
- Fig. 2: eine Explosionsdarstellung eines erfindungsgemässen Prüflingsmanipulators in einer Ansicht von oben; und

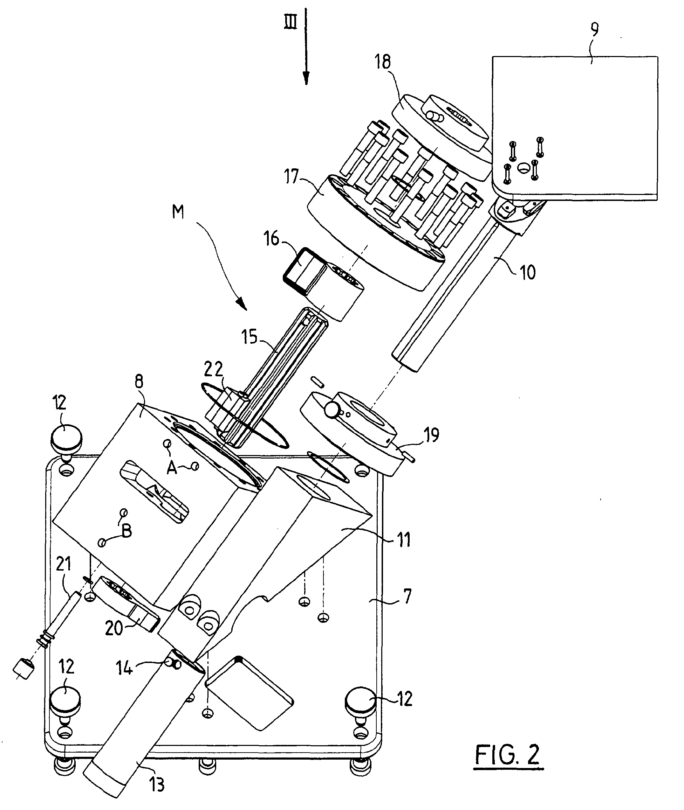

- Fig. 2: eine Ansicht in Richtung des Pfeiles III von Fig. 2.

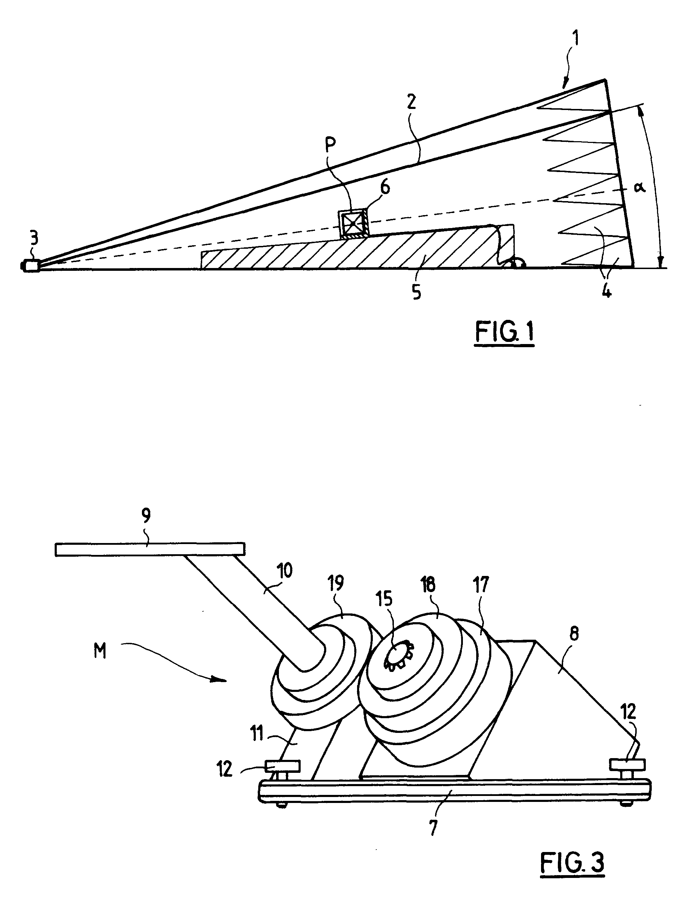

Fig. 1 zeigt einen Schnitt durch eine konische TEM-Zelle 1, wie sie zur Überprüfung der elektromagnetischen Verträglichkeit von Prüflingen verwendet wird. Unter elektromagnetischer Verträglichkeit versteht man einerseits die elektromagnetische Störfestigkeit, also die Immunität eines Betriebsmittels gegenüber von anderen Betriebsmitteln ausgesandter Störstrahlung, und andererseits die elektromagnetische Störaussendung, also Störungen, die das Betriebsmittel in and-ren Betriebsmitteln hervorrufen kann. Für Alarmanlagen sind Prüfverfahren und Prüfeinrichtung zum Nachweis der Störfestigkeit eines Prüflings gegen elektromagnetische Felder in der Europäischen Norm EN 50130-4 (Europäischer Produktefamilienstandard: Elektromagnetische Verträglichkeit, Anforderungen an die Störfestigkeit von Anlageteilen für Brand- und Einbruchmeldeanlagen sowie Personen-Hilferufanlagen) definiert. In dieser Norm ist festgelegt, dass die elektromagnetischen Felder durch die Benutzung von Antennen in reflexionsfreien oder fast reflexionsfreien Kammern erzeugt werden können, wobei der Prüfling der Beanspruchung in drei Ausrichtungen relativ zum Feld in der Weise zu unterziehen ist, dass die elektrischen (E)- und magnetischen (H)- Anteile des Feldes an jeder der drei rechtwinkeligen Achsen des Prüflings angelegt werden. Eine TEM-Zelle ist eine solche reflexionsfreie Kammer.

Gemäss Fig. 1 ist die konische TEM-Zelle 1 von der Konstruktion her eine geschlossene Streifenleitung mit einem asymmetrischen Innenleiter 2, wobei die Leitungen von einem Anschlusspunkt 3 wegführen, der an der Spitze der pyramidenförmig ausgebildeten Zelle angeordnet ist. An der dem Anschlusspunkt 3 gegenüberliegenden Grundfläche der Pyramide sind Hochfrequenz-Absorber 4 vorgesehen. In der konischen TEM-Zelle 1 können homogene elektromagnetische Felder in einem Frequenzbereich von einigen Hertz bis zu einigen Giga-Hertz erzeugt werden. TEM-Zellen funktionieren aber auch als Empfangsantennen für die Messung von abgestrahlten elektromagnetischen Störungen.

Neben den schon genannten Bedingungen für die Ausrichtung des Prüflings gelten noch die Randbedingungen, dass der Prüfling in der Zelle frei platzierbar (gesamtes Prüfvolumen im mittleren Drittel) und die Prüfhöhe verstellbar sein soll (Prüflingsschwerpunkt auf α/2, wenn α den Winkel zwischen Innenleiter 2 und der weiter entfernten gegenüberliegenden Seitenwand des Zelle 1 bezeichnet), und dass sich in der Zelle ausser dem Prüfling möglichst nur Teile aus elektromagnetisch neutralem Material befinden, damit die Homogenität des elektromagnetischen Feldes nicht beeinflusst wird.

Damit sich der Prüfling in der richtigen Höhe befindet, hat man bisher auf den Boden der Zelle 1 eine keilförmige Auflage 5 aus Hartschaumstoff gelegt, auf welcher der mit dem Bezugszeichen P bezeichnete Prüfling in die optimale Lage geschoben wurde. Optimal bedeutet in diesem Zusammenhang, dass einerseits der Prüfling P aus energetischen Gründen möglichst nahe an der Spitze der Zelle (Anschlusspunkt 3) platziert werden, und andererseits die Kantenlänge des Prüflings P maximal ein Drittel des Abstands zwischen dem Innenleiter 2 und dem Boden der konischen TEM-Zelle 1 an der Prüfposition betragen soll. Der Prüfling P ist auf einem speziellen Trägerwinkel 6 aus Holz mit drei rechtwinkelig zueinander angeordneten Seitenflächen befestigt, die bei der Prüfung nacheinander auf der Auflage 5 zu liegen kommen. Die Positionierung des Trägewinkels 6 mit dem Prüfling P erfolgt jeweils von Hand.

Der in den Fig. 2 und 3 dargestellte Prüflingsmanipulator M ersetzt die Auflage 5 und den Trägerwinkel 6 und ermöglicht eine automatische Verstellung des Prüflings P in die einzelnen Positionen. Der Prüfling P braucht nur noch vor der Prüfung auf dem Prüflingsmanipulator M befestigt und nach der Prüfung von diesem wieder entnommen zu werden. Dazwischen ist kein manueller Eingriff erforderlich, so dass die Prüfung automatisch ablaufen kann. Fig. 2 zeigt eine Explosionsdarstellung des Prüflingsmanipulators M in einer Ansicht von oben und Fig. 3 zeigt eine Vorderansicht in Richtung des Pfeiles III von Fig. 2.

Darstellungsgemäss besteht der Prüflingsmanipulator M im wesentlichen aus einer Bodenplatte 7, einem auf dieser angeordneten Gehäuse 8, einer aus einer Prüflingsplatte 9 und einer diese tragenden Hohlwelle 10 bestehenden Prüflingshalterung und einer auf der Bodenplatte 7 angeordneten Abstützung 11, in welcher die Hohlwelle 10 abgestützt und gelagert ist. Die Bodenplatte 7 ist zur Aufstellung auf dem Boden der TEM-Zelle 1 (Fig. 1) vorgesehen und weist im Bereich ihrer Ecken vier höhenverstellbare Justierschrauben 12 auf. In der Abstützung 11 ist eine Führungshülse 13 drehbar gelagert, in welcher die Hohlwelle 10 in Längsrichtung verschieb- und fixierbar gelagert ist. Die Fixierung in der gewünschten Position erfolgt mit einem Klemmbolzen 14. Die Hohlwelle 10 verläuft von der Bodenplatte 1 schräg nach oben und ist so orientiert, dass ihre Achse in einer Raumdiagonalen eines Würfels verläuft.

Die Hohlwelle 10 ist an ihrem freien Ende mir einem horizontal abgeschrägten Kopfteil versehen, auf den die Prüflingsplatte 9 aufgeschraubt ist. Die letztere ist parallel zur Bodenplatte 1 orientiert. Durch die Orientierung der Hohlwelle 10 in der Raumdiagonalen eines Würfels wird erreicht, dass ein auf der Prüflingsplatte 9 angeordneter Prüfling bei Drehung der Hohlwelle 10 um zweimal 120° die von der Europäischen Norm EN 50130-4 verlangte Ausrichtung relativ zum Feld erreicht, bei der die elektrischen und die magnetischen Anteile des Feldes an jeder der drei rechtwinkeligen Achsen des Prüflings angelegt werden. Die Längsverschiebbarkeit der Hohlwelle 10 in der Führungshülse 13 dient zur Einstellung der optimalen Höhe des Prüflings P in der TEM-Zelle mit dem Prüflingsschwerpunkt auf α/2 (Fig. 1). Die letztere Forderung gilt allerdings nur für konische TEM-Zellen.

Die Verdrehung der Hohlwelle 10 in den beiden Schritten von je 120° erfolgt durch einen im Gehäuse 8 angeordneten pneumatischen Antrieb, der durch eine sogenannte Flügelzelle (nicht dargestellt) gebildet ist. Diese besteht aus einer abgedichteten Kammer im Gehäuse 8 mit einem durch ein Luftpolster antreibbaren, auf einer die Kammer durchstossenden Keilwelle 15 angeordneten Schwenkflügel 16. Das Gehäuse 8 weist stirnseitig, gegen die Prüflingsplatte 9 hin, eine Öffnung auf, welche durch einen Deckel 17 abgeschlossen ist. Der Deckel 17 weist, ebenso wie die dem Deckel 17 gegenüberliegende Rückwand der Kammer eine Öffnung zum Durchtritt der Keilwelle 15 auf. Die mit ihren beiden Enden aus der Flügelzelle ragende Keilwele 15 trägt an ihrem vorderen Ende ein Keilwellenzahnrad 18, welches mit einem auf der Hohlwelle 10 fixierten Prüflingszahnrad 19 in Eingriff steht, und an ihrem hinteren Ende einen Anschlaghebel 20. Das Prüflingszahnrad 19 ist auf der Hohlwelle 10 mit einem Keil gegen Verdrehen gesichert.

Der Anschlaghebel 20 begrenzt die Verdrehung der Keilwelle 15 auf zweimal 120°. Die beiden Endpositionen des Anschlaghebels 20, 0° und 240°, sind durch entsprechende Anschläge im Gehäuse 8 definiert. Für die mittlere Position von 120° ist ein pneumatisch betätigbarer Anschlagzylinder 21 vorgesehen, der wahlweise in die Bewegungsbahn des Schwenkflügels 16 gestossen oder aus dieser herausgeschoben wird. Die Pneumatikanschlüsse am Gehäuse 8 sind durch Bohrungen A für den Antrieb des Schwenkflügels 16 und B für die Betätigung des Anschlagzylinders 21 angedeutet. Zwischen den beiden Anschlüssen A ist in der Kammer zwischen der Kammerwand und der Keilwelle 15 eine ortsfeste Kammerdichtung 22 vorgesehen, durch welche die Kammer in zwei Teilkammern unterteilt ist. Je nachdem, durch welche der beiden Bohrungen A Luft zugeführt wird, rotiert der Schwenkflügel 16 in die eine oder die andere Richtung.

Die Führungshülse 13 ist an ihrem hinteren Ende mit einem Bund versehen, welcher an einer entsprechenden Abstufung der Abstützung 11 anliegt. Damit sind die Führungshülse 13 und die mit dieser durch den Klemmbolzen 14 verbundene Hohlwelle 10 gegen Herausrutschen aus der Abstützung in der Richtung von der Bodenplatte 7 weg gesichert. Das auf der Hohlwelle 10 fixierte Prüflingszahnrad 19 sichert Hohlwelle 10 und Führungshülse 13 gegen Verrutschen zur Bodenplatte 7 hin.

Die Kabel zu den elektrischen Anschlüssen des Prüflings sind durch die Hohlwelle 10 zur Bodenplatte 1 und von dort zu entsprechenden Anschlüssen in der Zelle 1 geführt. Das hat den Vorteil, dass die Kabel geschützt sind und sich nicht verhaken oder in den Zahnrädern verklemmen können. Ausserdem sind die Kabel immer in der gleichen Lage vom Prüfling weggeführt, was Vergleiche zwischen den einzelnen Messungen vereinfacht.

Wie schon erwähnt wurde, muss der Prüflingsmanipulator M aus einem Material bestehen, welches das elektromagnetische Feld in der TEM-Zelle nicht beeinflusst. Für die Bodenplatte 7 und die Prüflingshalterung 9 wird MFD, eine mitteldichte Faserplatte verwendet. MFD besteht zum grössten Teil aus Holz und kann sehr gut bearbeitet werden. Für die restlichen Teile des Prüfmanipulators M wird Polyacetal (POM) verwendet. Dieses auch als Polyoxymethylen bezeichnete Material zeigt hervorragende Eigenschaften in bezug auf Festigkeit und Steifigkeit.

Für die Befestigung des Prüflings auf der Prüflingsplatte 9 besteht eine Reihe vom Möglichkeiten, die vom Aufspannen mit einem starken Gummiband über Festklemmen mit geeigneten Klemmmitteln bis zum Anschrauben reicen. Wenn verschiedene Prüflinge von gleicher Gehäuseform geprüft werden sollen, wird es sich in den meisten Fällen lohnen, auf der Prüflingsplatte 9 einen geeigneten Sockel oder dergleichen zu montieren.

Es empfiehlt sich, immer mehrere Prüflingshalterungen (Hohlwellen 10 mit aufgeschraubter Prüflingsplatte 9) parat zu haben, um einen Prüfling schon während des Ablaufs einer anderen Prüfung auf der Prüflingsplatte 9 befestigen und den Wechsel der Prüflinge durch einfaches Lösen des Klemmbolzens 14 und Auswechseln der Prüflingshalterung vornehmen zu können.

Sämtliche Funktionen des Prüflingsmanipulators M mit Ausnahme der Drucküberwachung der Pneumatik werden von einem Mikrokontroller oder Mikroprozessor gesteuert. Jede Messung wird vorzugsweise von einem Rechner gestartet, wobei zuerst der Prüflingsmanipulator M von Hand in die Ausgangsposition gedreht wird, in der die Verschwenkung der Prüflingsplatte 0° beträgt. Eine Automatisierung dieses Schritts würde Sensoren zur Überwachung der Position der Prüflingsplatte 9 erfordern. Dann beginnt die Messung, wobei nach Abschluss der Messung in einer bestimmten Position die Prüflingsplatte 9 automatisch in die nächste Position gedreht wird. Nach Abschluss der Messung in der dritten Position, in der die Verdrehung der Prüflingsplatte 240° beträgt, kann die Prüflingsplatte automatisch wieder in die Grundposition zurückgedreht werden. Es empfiehlt sich aber, die Prüflingsplatte in der dritten Position zu belassen, weil dann der Anwender sofort erkennt, ob die Prüfung ordnungsgemäss abgelaufen ist und sich der Prüflingsmanipulator nicht etwa verklemmt hat.

Die Beschreibung des Prüflingsmanipulators M in Zusammenhang mit einer konischen TEM-Zelle soll keine Einschränkung bedeuten. Der Prüflingsmanipulator ist vielmehr für alle Arten von TEM-Zellen geeignet.

## Patentansprüche

1. Prüflingsmanipulator für TEM-Zellen für die Platzierung eines Prüflings in drei verschiedenen Raumpositionen innerhalb der Zellen (1), **dadurch gekennzeichnet, dass** der Prüflingsmanipulator (M) eine rotierbare Prüflingshalterung sowie Mittel für deren Antrieb aufweist, und dass die Prüflingshalterung so ausgebildet ist, dass der Prüfling (P) in einer Raumdiagonale eines Würfels in Schritten von 120° verdrehbar ist.

2. Prüflingsmanipulator nach Anspruch 1, **dadurch gekennzeichnet, dass** die Prüflingshalterung auf einer Bodenplatte (7) angeordnet ist und eine parallel zur Bodenplatte (7) orientierte Prüflingsplatte (9) und eine diese tragende Antriebswelle (10) aufweist, und dass die Mittel für den Antrieb der Prüflingshalterung in einem auf der Bodenplatte (7) montierten Gehäuse (8) angeordnet sind.

3. Prüflingsmanipulator nach Anspruch 2, **dadurch gekennzeichnet, dass** die Antriebswelle (10) im Gehäuse (8) oder in einer auf der Bodenplatte (7) angeordneten Abstützung (11) so gelagert ist, dass ihre Längsachse in Richtung einer Raumdiagonalen eines Würfels orientiert ist.

4. Prüflingsmanipulator nach Anspruch 3, **dadurch gekennzeichnet, dass** die Antriebswelle durch eine Hohlwelle (10) gebildet und in der Abstützung (11) in Längsrichtung verschieb- und justierbar gelagert ist.

5. Prüflingsmanipulator nach Anspruch 4, **dadurch gekennzeichnet, dass** die Mittel für den Antrieb der Prüflingshalterung durch einen auf die Hohlwelle (10) wirkenden pneumatischen Antrieb gebildet sind.

6. Prüflingsmanipulator nach Anspruch 5, **dadurch gekennzeichnet, dass** der pneumatische Antrieb eine Flügelzelle mit einem auf einer ersten Welle (15) befestigten Schwenkflügel (16), ein auf der genannten Welle (15) befestigtes erstes Zahnrad (18) und ein mit diesem in Eingriff stehendes und auf der Hohlwelle (10) befestigtes zweites Zahnrad (19) umfasst.

7. Prüflingsmanipulator nach Anspruch 6, **dadurch gekennzeichnet, dass** die erste Welle (15) durch eine Keilwelle gebildet und dass auf dieser ein Anschlaghebel (20) fixiert ist.

8. Prüflingsmanipulator nach Anspruch 7, **dadurch gekennzeichnet, dass** im oder am Gehäuse (8) zwei dem Anschlaghebel (20) zugeordnete feste Anschläge für die beiden Drehwinkel des Prüflings (P) von 0° und 240° vorgesehen sind, und dass für den mittleren Drehwinkel von 120° ein in die Bahn des Anschlaghebels (20) hinein- und aus dieser herausbewegbarer Anschlagzylinder (21) vorgesehen ist.

9. Prüflingsmanipulator nach Anspruch 8, **dadurch gekennzeichnet, dass** der Anschlagzylinder (21) einen pneumatischen Antrieb aufweist.

10. Prüflingsmanipulator nach einem der Ansprüche 5 bis 9, **dadurch gekennzeichnet, dass** die Kabel zu den elektrischen Anschlüssen des Prüflings (P) durch die Hohlwelle (10) zur Bodenplatte (7) geführt sind.

11. Prüflingsmanipulator nach einem der Ansprüche 2 bis 10, **dadurch gekennzeichnet, dass** die Bodenplatte (7) und die Prüflingsplatte (9) aus einer mitteldichten Faserplatte und die übrigen Teile des Prüflingsmanipulators (M) aus Polyacetal (POM) hergestellt sind.
